# EUROPEAN PATENT APPLICATION

(11) **EP 2 674 996 A1**
(43) Date of publication of application: **18.12.2013**
(21) Application number: 12172125.2
(22) Date of filing: 15.06.2012
(51) Int. Cl.: H01L 51/00, H01L 51/05, B82Y 10/00

(54) **Method for growing nanostructures in recessed structures**

(71) Applicant: Imec VZW, 3001 Leuven (BE)
(72) Inventor: Cott, Daire J., B-3001 Leuven (BE); Armini, Silvia, B-3001 Leuven (BE)
(74) Representative: Ego, Christophe

(57) **Abstract**

A method for growing elongated nanostructures (7) only on the bottom (3) of a recessed structure (4), the method comprising:
a. providing a substrate (5) comprising said recessed structure (4), said recessed structure (4) comprising:
o said bottom (3), and
o at least one sidewall (6),

b. modifying the chemical nature of the surface of said at least one sidewall (6) so that said at least one sidewall (6) has a lower affinity than said bottom (3) for a catalyst film (2),
c. providing said catalyst film (2) onto said bottom (3),
d. thermally and/or plasma treating said film (2) so as to form said catalyst nanoparticles (1), and
e. growing elongated nanostructures (7) in said recessed structure (4) using the catalyst nanoparticules (1).

## Description

### Technical field

The present disclosure relates to a method for selectively forming a catalyst film on the bottom of a recessed structure so as to permit the growth of elongated nanostructures therefrom. The present disclosure further relates to substrates comprising said recessed structures and said catalyst film or nanostructures.

### Background art

Carbon Nanotubes (CNTs) have been identified as one of the most promising candidates to extend and even replace materials currently used in microelectronic manufacturing. Metallic CNTs have been proposed as nano-electronic interconnects due to their high current carrying capacity, whereas semiconducting CNTs have been indicated as nanoscale transistor elements due to their large range band gap. These and similar applications cannot be fully accomplished yet since the fabrication of any CNT-based device still faces a variety of unsolved issues, which vary from one application to another but may, however, be similar in some respects.

One such issue is related to the lack of a scalable method for growing CNT's exclusively in the bottom of recessed structures. Furthermore, CNTs must be integrated efficiently and economically into various device architectures. To realize their full potential in various device applications, selective CNT growth is a very important issue.

One promising technique for providing CNTs in recessed structures of a substrate is to first deposit a film catalyst precursor on the substrate in such a way as to cover the bottom of said recessed structures, followed by annealing of the film catalyst precursor in order to form catalyst particles. This method however leads to the presence of catalyst particles on the sidewalls of the recessed structures. This in turn leads to the growth of CNTs perpendicularly to said walls, thereby disturbing the vertical CNT growth process. Solutions to this problem have been proposed such as the followings:

Sato et al (Proc. IEEE Int. Technol.Conf., 2006, p. 230.) discloses the deposition of the catalyst by the use of Laser ablation and low-pressure differential mobility analyzer (DMA). Although this solution is CMOS compatible, it is difficult to upscale for manufacturing purposes and it implies the use of specific, complicated and expensive equipments.

Romo-Negreira et al (JES 157, (3) K47-K51, 2010) discloses the electrodeposition of metal nanoparticles for selective CNT growth. This method involves however the use of an electric field between the via bottom and a metal solution. This solution is not CMOS compatible.

T. Iwasaki et al. (Carbon 45 (2007) 2351―2355) discloses the deposition of a metal catalyst layer before patterning and etching out the via or contact recessed structure structure. This solution is however not CMOS compatible as the metal layer may act as a common bottom electrode.

There is therefore a need in the art for a CMOS compatible, easy to upscale and inexpensive method enabling the growth of CNTs exclusively from the bottom of a recessed structure, especially a high aspect ratio recessed structure, without growth from the sidewalls.

### Summary of the disclosure

It is an aim of the present disclosure to provide a method for growing elongated nanostructures only on the bottom of a recessed structure or recessed structure.

This aim is achieved according to the disclosure with the method showing the technical characteristics of the first independent claim.

In embodiments, the method of the disclosure can be used to form a contact plug or an interconnect structure. The contact plug or the interconnect structure may comprise (at least) a bundle of elongated nanostructures. A bundle of elongated structures is formed of a plurality of elongates nanostructures having substantially the same orientation. An example of an interconnect structure is e.g. a via. According to the present disclosure, the problem of forming contact plugs/interconnect structures in narrow structures having high aspect ratio (something that could not be achieved by electrochemical plating of Cu or W) is solved. It is a challenge to fill by electrochemical plating recess structures having a diameter of 25nm or below and an aspect ratio of 2 or more as currently used for advanced logic and memory circuits. The method of the disclosure offers an advantageous alternative to electrochemical plating. The method of the disclosure is suitable to fill through-silicon-via (TSV) structures and in particular TSV with a high aspect ratio (e.g. 20, 50, up to 100). TSVs are used in the 3D technology to connect two different layers of a chip in which two or more layers of active electronic components are integrated both vertically and horizontally. The aspect ratio of a recessed structure (recessed structure, via, plug) is the depth to width ratio of said recessed structure.

In a first aspect, the present disclosure relates to a method for forming a catalyst film only on the bottom of a recessed structure, the method comprising:
a. providing a substrate comprising said recessed structure, said recessed structure comprising:
   o said bottom, said bottom having a first affinity for said catalyst film, and
   o at least one sidewall having a second affinity for said catalyst film,
b. modifying the chemical nature of the surface of said at least one sidewall so that said at least one sidewall has a lower affinity than said bottom (3) for said catalyst film (2), and
c. providing said catalyst film (2) onto said bottom (3) by either atomic layer deposition or chemical vapour deposition.

This method is advantageous as it permits to obtain a recessed structure having a catalyst film only on the bottom of the recessed structure and not on the one or more sidewalls of the recessed structure. This in turn permits to grow elongated nanostructures only from the bottom of the recessed structure, thereby improving the ability of the nanostructures to serve as good electrical contacts. As used herein, the term *"affinity"* relates to the force attracting entities to each other. This force can be strong enough to create covalent bounds between atoms belonging to each entity but this force is more typically either electrostatic or of the Van der Waals type. If A has a lower affinity for B than A' has, it can mean that A is less attracted by B than A' is or it can mean that A is repelled by B while A' is attracted by B or it can mean that A is more repelled by B than A' is. The affinity of a surface can be modified by functionalising said surface with chemical groups. This can typically be achieved by forming a self-assembled monolayer (SAM) on said surface. In order to decrease the affinity of a surface for a catalyst film, a SAM bearing hydrophobic non-reactive groups can typically be used. Such SAMs are inert to chemical functionalisation by an ALD reaction. Due to the hydrophobic non-reactive coating, the tendency for the surface to form chemical bonds or to interact electrostatically with the catalyst film is reduced or eliminated.

An embodiment of the first aspect relates to a method for forming catalyst nanoparticles on the bottom of a recessed structure, the method comprising steps (a) to (c) above and further comprising a step (d) after step (c) of thermally or plasma treating said film so as to form catalyst nanoparticles.

In embodiments, step (c) may comprise the steps of:
i.depositing a metal or metal oxide catalyst film in said bottom, and
ii.thermally or plasma treating said film so as to form said catalyst nanoparticles.

The transformation of the catalyst film into nanoparticles can be performed by thermal and/or plasma assisted methods, e.g. by performing an annealing or heating step on the substrate. Annealing the substrate may be performed by, for example, a Rapid Thermal Anneal (RTA) at a temperature in the range of between 200°C and 750°C, preferably between 200°C and 400°C. The temperature at which annealing is performed may depend on the type and thickness of the catalyst film from which the nanoparticles have to be formed. Preferably, annealing the substrate may be performed for a time period of at least one minute up to a few minutes. Preferably, the annealing may be performed under an inert N₂ or Ar atmosphere. The annealing may also be performed under a reducing gas atmosphere such as H₂ or NH₃. The annealing may also be performed under vacuum without breaking the vacuum during annealing.

Another embodiment of the first aspect relates to a method for forming elongated nanostructures on the bottom of a recessed structure, the method comprising the steps (a) to (d) above and further comprising a step (e) after step (d) of growing elongated nanostructures in said recessed structure using the nanoparticles provided at the bottom of said recessed structure as a catalyst.

According to the present disclosure, with the term elongated nanostructures is meant any pieces of solid material in the form of wires (nanowires), tubes (nanotubes), rods (nanorods) and similar elongated substantially cylindrical or polygonal nanostructures having a longitudinal axis. A cross-dimension of the elongate nanostructures preferably lies in the region of 1 to 500 nm. According to the disclosure, organic elongated nanostructures, such as e.g. carbon nanotubes (CNTs), or inorganic elongated nanostructures, such as e.g. semiconducting nanowires (e.g. silicon nanowires) may be used. Hereinafter, the disclosure will be described by means of CNTs. This is not intended to limit the disclosure in any way. The present disclosure also applies to other elongated nanostructures as described above.

Growing elongate nanostructures in the recessed structure may be performed by a chemical vapour deposition process or a plasma enhanced chemical vapour deposition process.

This may, for example, be done by:
● providing a carbon source and an assistant gas, and
● growing elongate nanostructures by heating the substrate.

The method may use a carbon source such as e.g. CH₄ and C₂H₂, C₂H₄ and gases such as N₂ and/or H₂ as assistant (carrier) gases. Most preferably, the method may be performed at temperatures lower than 900°C, e.g. between 300°C and 800°C, as growth temperature. Other growth temperatures may be advantageous. For example, the growth temperature may be lower than 450°C to avoid damage to material of the substrate on which the CNTs are grown. For example, using other carbon sources than C₂H₄, growth temperatures lower than 500°C may also be suitable for growing CNTs. In general, the diameter of the formed CNTs may be consistent with, i.e. may be substantially the same as, the diameter of the original catalyst nanoparticles. With decreasing nanoparticle sizes, the diameter of the CNTs may become smaller, following a one to one relation. Massive growth of CNTs typically occurs for pure metal nanoparticles up to 800°C.

In embodiments, said elongated nanostructures may be carbon nanotubes. Carbon nanotubes are particularly advantageous as they are excellent conductors, thereby permitting their use as electrical contacts.

In embodiments, said bottom and said at least one sidewall may be of different chemical natures. This has the advantage of permitting the selective attachment of self-assembled monolayers (SAMs) on one of the surfaces.

In embodiments, step (b) may comprise providing a hydrophobic self-assembled monolayer on said at least one sidewall. This is particularly advantageous as the catalyst layer, typically containing metal, has a low affinity for hydrophobic surfaces. This therefore prevents the metal layer to form on the sidewalls.

In embodiments, said hydrophobic self-assembled monolayer may comprise an organosilane, an organophosphate or an organophosphonate.

In embodiments, said hydrophobic self-assembled monolayer may be a monolayer of organosilane, organophosphate or organophosphonate molecules.

Organosilanes have a high affinity for surfaces such as SiO₂ or other metal oxide dielectrics. Organophosphates or organophosphonates also have high affinity for metal oxide dielectrics. This is advantageous for achieving selective functionalisation of the sidewalls.

In embodiments, said organosilane may be of general formula R-SiCl₃ or R-SiOR'₃, preferably R-SiCl₃ wherein R is a hydrocarbyl group wherein one or more hydrogen atoms are optionally substituted for fluorine atoms, and R' is an alkyl.

In embodiments, said organophosphates or organophosphonates may be of general formula R-O-P(O)(OH)₂ (or a salt thereof) or R-P(O)(OH)₂ (or a salt thereof) respectively, wherein R is a hydrocarbyl group wherein one or more hydrogen atoms are optionally substituted for fluorine atoms. A salt of R-OP(O)(OH)₂ can for instance be R-O-P(O)(O⁻)₂(NH₄⁺)₂. A salt of R-P(O)(OH)₂ can for instance be R-P(O)(O⁻)₂(NH₄⁺)₂.

In embodiments, said group R may have from 1 to 24 carbon atoms. This is advantageous as it provides enough Van der Waals interaction between the R chains to enable the self-assembling process to occur and the ordering and density of the molecules in the SAM to be maximized.

In embodiments, said group R may be linear. This is advantageous as it facilitates the formation of dense SAMs.

In embodiments, wherein one or more hydrogen atoms are substituted for fluorine atoms, R may have the general formula ―(CH₂)ₙ-(CF₂)ₘ-F, wherein n is from 0 to 7 and m is from 1 to 24.

In embodiments, said alkyl may be selected from methyl, ethyl, n-propyl and isopropyl.

In embodiments, said organosilanes may be selected from hydrocarbyl trialkoxysilanes and hydrocarbyl trichlorosilanes.

The table below gives some examples of suitable organosilanes:

| |
|---|
| Decyltrichlorosilane, Decyltrialkoxysilane |
| Undecyltrichlorosilane, Undecyltrialkoxysilane |
| Dodecyltrichlorosilane, Dodecyltrialkoxysilane |
| (1H,1H,2H,2H-perfluorodecyl)trichlorosilane, (1H,1H,2H,2H-perfluorodecyl)trialkoxysilane |
| 11-Bromoundecyltrichlorosilane, 11-Bromoundecyltrialkoxysilane |
| n-Octyltrichlorosilane, n-Octyltrimethoxysilane |
| Butyltrichlorosilane, Butyltrialkoxysilane |
| Hexadecyltrichlorosilane, Hexadecyltrialkoxysilane |
| n-octadecyltrichlorosilane, n-octadecyltrialkoxysilane |

In embodiments, the method may further comprise a step (f) after step (a) and before step (c) of modifying the chemical nature of said bottom. This can be advantageous for various reasons: 1) in embodiments, it permits to increase the affinity of bottom for the catalyst layer; 2) in other embodiments, when the chemical nature of the bottom is modified before to modify the chemical nature of the walls, it permits to passivate at least partially the bottom, thereby improving the selectivity of the chemical nature modification of the sidewalls. In these last embodiments, the bottom may be subsequently heated to restore selectively the original chemical nature of the bottom.

In embodiments, said step (f) may lead to a bottom having an increased affinity for said catalyst nanoparticles.

In embodiments, said step (f) may comprise providing a self-assembled monolayer on said bottom. This is advantageous as it can be easily and efficiently performed. Furthermore, the chemical nature of the SAM can be tailored to the specific situation.

In embodiments, step (f) may be performed before step (b). This permits to passivate at least partially the bottom, as mentioned above.

In embodiments, step (f) may comprise providing a self-assembled monolayer on said bottom, wherein said self-assembled monolayer is preferably hydrophilic. This permits to increase the affinity of bottom for the catalyst layer.

In embodiments, the method may comprise a step (f) after step (a) and before step (b) comprising providing a self-assembled monolayer on said bottom.

In embodiments where the SAM provide on the bottom will be eliminated in a subsequent step via heating, it is not necessary that it be hydrophilic.

In embodiments, said self-assembled monolayer may be a monolayer of organosulfur compounds, preferably of a single organosulfur compound. Using a single type of organosulfur compounds has been shown to lead to a better selectivity. See comparative example 4.

Suitable organosulfurs may for instance have the general formula H-S-R"-A or A-R"-S-S-R"-A, wherein R" is an alkylene group and preferably a linear alkylene group and wherein said "A" is a polar group such as but not limited to ―NH₂, -OH, -CN, -COOH or ―X, wherein X is a halogen such as e.g. Br. Said alkylene group preferably has from 2 to 22 carbon atoms, 2 to 12 carbon atoms, or 2 to 10 carbon atoms.

The table below gives some examples of suitable organosulfurs:

| |
|---|
| 11-Mercapto-1-undecanol |
| 4-Aminothiophenol |
| 11-Amino-1-undecanethiol hydrochloride |
| (11-mercaptoundecyl) triethyleneglycol |
| 1-Decanethiol |
| 1-Dodecanethiol |
| 1-Propanethiol |
| 3-Mercapto-1-propanol |

In embodiments, said self-assembled monolayer may be a monolayer of organoselenium compounds. Suitable organoselenium compounds may for instance have the general formula H-Se-R"-A or A-R"-Se-Se-R"-A, wherein R" is an alkylene group and preferably a linear alkylene group and wherein said "A" is a polar group such as but not limited to ―NH₂, -OH, -CN, -COOH or ―X, wherein X is a halogen such as e.g. Br. Said alkylene group preferably has from 2 to 22 carbon atoms, 2 to 12 carbon atoms, or 2 to 10 carbon atoms.

In embodiments, said bottom provided in step (a) may be made of an electrically conductive material. This is typically the case since growing CNTs is especially useful for establishing an electrical connection.

In embodiments of the present disclosure, the term "substrate" may include any underlying material or materials that may be used, or upon which a device, a circuit or an epitaxial layer may be formed. In preferred embodiments, this "substrate" may include a semiconductor substrate such as e.g. a doped silicon, a gallium arsenide (GaAs), a gallium arsenide phosphide (GaAsP), an indium phosphide (InP), a germanium (Ge), or a silicon germanium (SiGe) substrate. According to alternative embodiments, the "substrate" may include for example, an insulating layer such as a SiO₂ or an Si₃N₄ layer in addition to a semiconductor substrate portion. Thus, the term substrate also includes silicon-on-glass, silicon-on sapphire substrates. The term "substrate" is thus used to define generally the elements that underlie a layer or portions of interest. Also, the "substrate" may be any other base on which a layer is formed, for example a glass or metal layer. Preferably, the substrate may be a silicon substrate.

According to embodiments of the disclosure, the substrate may comprise a base substrate. Forming a recessed structure in the substrate may be performed by forming recessed structures in the base substrate. This may be advantageous to be used in the manufacturing of e.g. semiconductor devices where a contact is required between the elongate nanostructures which may be grown on the substrate using the nanoparticles as a catalyst and the base substrate.

According to other embodiments of the disclosure, the substrate may comprise a base substrate and a dielectric layer. Forming a recessed structure in the substrate may be performed by forming a recessed structure in the dielectric layer of the substrate. This may be advantageous to be used in the manufacturing of e.g. semiconductor devices where there may not be a contact between elongate nanostructures which may be grown on the substrate using the nanoparticles as a catalyst and the base substrate.

In embodiments, said at least one sidewall provided in step (a) may be made of a dielectric material.

In embodiments, said recessed structures may be made using semiconductor processes well known to the person skilled in the art such as lithography and dry etching. In embodiments, said recessed structures may have a diameter of from 5 nm and 5000 nm, for example a diameter of 10 nm to 4000 nm, The present disclosure is especially useful for recessed structures having a diameter of between 5 and 25 nm. The aspect ratio of the recessed structure may, for example, be 2 or more, 5 or more, 10 or more but is preferably 15 or more and most preferably 20 or more. Typically, the aspect ratio may be up to 100. The present disclosure is especially useful for recessed structures having a diameter of from 5 and 25 nm and having an aspect ratio of from 2 to 100. While alternative to the present disclosure exist for recessed structures of small aspect ratio, the inventors are not aware of any alternatives to the methods of the present disclosure for selectively forming a catalyst film in the bottom of a recessed structure having an aspect ratio of 15 or more.

In embodiments, said recessed structure may be selected from a back end of line via, a back end of line contact recessed structure and a through silicon via.

In embodiments, said bottom may be made of a material selected from nickel silicide, cobalt silicide, titanium nitride, silicon and Al₂O₃.

In embodiments, said bottom may be made of titanium nitride.

In embodiments, said catalyst film may be suitable for forming catalyst nanoparticles upon heating and/or plasma treatment.

In embodiments, said catalyst film may be made of a material such that, when heated up and/or when plasma treated, it leads to formation of catalyst nanoparticles.

In embodiments, said catalyst film or catalyst nanoparticles may contain metal. In embodiments, said metal may be selected from the list consisting of Co, Ti, Pt, W, Ni and Fe.

In embodiments, said catalyst film or catalyst nanoparticles may be made of pure metal or may be made of metal allow or may be made of metal oxide.

In preferred embodiments, said catalyst film or catalyst nanoparticles may be made of Ni, Co or Fe.

In embodiments, the catalyst film may comprise more than one layer of material, for example, two layers, preferably two layers formed of metal such as e.g. Co, Ti, Pt, W, Ni or Fe. Furthermore, the combination of two or more layers can also be a combination of at least one pure metal layer and at least one non-pure metal layer and/or at least one non-metal layer.

In embodiments, where the catalyst film comprises more than one layer of material, at least one of the layers may be a metal-containing layer.

In any embodiment herein, the metal layer may be preferably deposited using PVD, ALD or CVD. ALD and CVD are most preferred.

Preferably, the thickness of the catalyst film may be lower than 20 nm and may more preferably be between 1 nm and 10 nm.

According to other embodiments, the thickness of the catalyst film may be lower than 1 nm, which may lead to very small nanoparticles with a diameter in the range of between 0.2 nm and 0.5 nm.

In embodiments, step (b) may comprise:
i.Selectively providing a self-assembled monolayer on said bottom,
ii.providing a hydrophobic self-assembled monolayer on said at least one sidewall so as to decrease its affinity for said catalyst layer below said first affinity, and
iii.heating up said bottom so as to selectively remove at least part of said self-assembled monolayer from said bottom.

This embodiment is particularly advantageous as it provides a very good selectivity (see examples).

In embodiments, in step (iii), said bottom may be heated up to a temperature comprised in the range from 360°C to 540°C, preferably 380°C to 520°C, more preferably 400°C to 500°C, yet more preferably from 420°C to 480°C.

In embodiments, the self-assembled monolayer provided on said bottom may be such as to be more easily thermally desorbed from said bottom than said hydrophobic self―assembled monolayer from said at least one sidewall. For instance, the self-assembled monolayer provided on said bottom may comprise an organosulfur or an organoselenium (preferably an organosulphur) and the hydrophobic self-assembled monolayer may comprise an organosilane, an organophosphate or an organophosphonate (preferably an organosilane).

Disulfides of the formula A-R"-S-S-R"-A are advantageous for forming the self-assembled monolayer on said bottom because they are more easily desorbed than their thiol A-R"-SH counterparts. Similarly, Diselenides of the formula A-R"-Se-Se-R"-A are advantageous for analoguous reasons.

Organosulphur and organoselenium compounds having polar functional groups are advantageous as they tend to form better packed monolayers with a reduced area per molecule.

Branched organosulphur and organoselenium compounds having complementary H-bond donors/acceptors in the organic chains are advantageous as they tend to form better packed monolayers with a reduced area per molecule. As used herein and unless provided otherwise, branched compounds having complementary H-bond donors/acceptors in the organic chains are compounds having a branching carbon leading to at least (and preferably) two branches, said compounds having at least a H-donor on a first of said at least two branches and a H-acceptor on a second of said at least two branches, wherein said H-donor and said H-acceptor are at the same distance from said branching carbon. For instance, both the H-acceptor and the H-donor could be in α of said branching carbon. As another example, they could be both in β of said branching carbon. Examples of such compounds and of their synthesis are given Chechik et al, Langmuir 1998, 14, 3003-3013.

In embodiments, the organosulphur or organoselenium compound may comprise an electron withdrawing group. Without being bound by theory, the mechanism of chemisorptions of organothiol or organoselenium compounds on metals can generally be described as an oxidative addition of the S-H or Se-H bond followed by the reductive elimination of hydrogen. Electron withdrawing groups destabilize the bond S-metal or Se-metal and therefore favour the thermal desorption of the organothiol or organoselenium from the surface. 4-Aminothiophenol is an example of an organothiol having an electron withdrawing group.

In embodiments, shorter organosulfur or organoselenium compounds (wherein R comprises from 1 to 12 carbon atoms, preferably 1 to10 carbon atoms) are advantageous because they permit only limited Van der Waals interactions, thereby permitting only limited thermal stability of the monolayer.

In embodiments, said bottom may be made of Al₂O₃ and said catalyst nanoparticles are made of Fe, Co or Ni.

In embodiments, said elongated nanostructures may be a bundle of elongated nanostructures.

In embodiments, said elongated nanostructures may be suitable for serving as an interconnect structure.

In embodiments, said elongated nanostructures may be a bundle of elongated nanostructures for forming an interconnect structure.

In a further aspect, the present disclosure relates to the use of the method of any embodiment of the first aspect in semiconductor processing.

In a further aspect, the present disclosure relates to a substrate comprising a recessed structure having a bottom and at least one sidewall, said recessed structure having catalyst nanoparticles or a catalyst film selectively on said bottom, said substrate further comprising a hydrophobic self-assembled monolayer on said at least one sidewall.

In a further aspect, the present disclosure may relate to a substrate comprising a recessed structure having a bottom and at least one sidewall, said recessed structure having elongated nanostructures selectively on said bottom, said substrate further comprising a hydrophobic self-assembled monolayer (8) on said at least one sidewall.

In a further aspect, the present disclosure relates to a semiconductor device comprising a substrate as defined in any of the further aspects above.

In embodiments, said semiconductor device may comprise a plurality of semiconductor devices as defined above, interconnected by means of said elongated nanostructures.

### Brief description of the drawings

The disclosure will be further elucidated by means of the following description and the appended figures.
Figure 1 shows the contact angle obtained directly after the deposition of dodecyltrichlorosilane on SiO₂ and TiN surfaces, as well as after annealing at different temperatures.
Figure 2 shows the contact angle obtained directly after the successive deposition of 11-mercapto-1-undecanol and dodecyltrichlorosilane on SiO₂ and TiN surfaces, as well as after annealing at different temperatures, illustrating an embodiment of the present disclosure.
Figure 3 shows the contact angle obtained directly after the successive deposition of 11-mercapto-1-undecanol, 3-mercapto-1-propanol and dodecyltrichlorosilane on a SiO₂ surface, as well as after annealing.
Figure 4 shows the contact angle obtained directly after the successive deposition of 11-mercapto-1-undecanol, 3-mercapto-1-propanol and dodecyltrichlorosilane on a TiN surface, as well as after annealing.
Figure 5 shows the contact angle obtained directly after the successive deposition of 4-aminothiophenol and dodecyltrichlorosilane on a SiO₂ surface, as well as after annealing, illustrating an embodiment of the present disclosure.
Figure 6 shows the contact angle obtained directly after the successive deposition of 4-aminothiophenol and dodecyltrichlorosilane on a TiN surface, as well as after annealing, illustrating an embodiment of the present disclosure.
Figure 7 shows the contact angle obtained directly after the successive deposition of 1-dodecanethiol and dodecyltrichlorosilane on a SiO₂ surface, as well as after annealing, illustrating an embodiment of the present disclosure.
Figure 8 shows the contact angle obtained directly after the successive deposition of 1-dodecanethiol and dodecyltrichlorosilane on a TiN surface, as well as after annealing, illustrating an embodiment of the present disclosure.
Figure 9 shows the contact angle obtained directly after the successive deposition of 1-propanethiol and dodecyltrichlorosilane on a SiO₂ surface, as well as after annealing, illustrating an embodiment of the present disclosure.
Figure 10 shows the contact angle obtained directly after the successive deposition of 1-propanethiol and dodecyltrichlorosilane on a TiN surface, as well as after annealing, illustrating an embodiment of the present disclosure.
Figure 11 shows the contact angle obtained directly after the successive deposition of 3-mercapto-1-propanol and dodecyltrichlorosilane on a SiO₂ surface, as well as after annealing, illustrating an embodiment of the present disclosure.
Figure 12 shows the contact angle obtained directly after the successive deposition of 3-mercapto-1-propanol and dodecyltrichlorosilane on a TiN surface, as well as after annealing, illustrating an embodiment of the present disclosure.
Figure 13 illustrates a method according to an embodiment of the present disclosure.
Figure 14 illustrates another method according to an embodiment of the present disclosure.
Figure 15 illustrates a step of a method according to an embodiment of the present disclosure.
Figure 16 illustrates a next step of the method illustrated in Figure 15.
Figure 17 illustrates method steps toward the growth of elongated nanostructures from a modified substrate obtained in any embodiment of the present disclosure.

### Detailed description of preferred embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

### A. General procecure for the examples:

### SAM deposition.

For the SAM deposition experiments, 2 x 2 cm² Si and TiN coupons have been used as substrates. SAMs derived from the Dodecyltriethoxysilane, n-deciltrimethoxysilane and Dodecyltrichlorosilane molecules were deposited on ca. 2 nm SiO₂ and slightly oxidized TiN surfaces formed after a cleaning step consisting in 15 min exposure to a UV-ozone treatment in a Jelight UVO-Cleaner. SAMs derived from the 11-mercapto-1-undecanol, 3-Mercapto-1-propanol, 4-aminothiophenol, 1-dodecanethiol, 1-propanethiol and 3-mercapto-1-propanol were selectively deposited on the TiN surface vs. the Si oxide surface.

For the formation of the silane SAMs (Dodecyltriethoxysilane, n-deciltrimethoxysilane and Dodecyltrichlorosilane), the SAMs deposition procedure consisted in the immersion of the clean SiO₂ and TiN surfaces in a 5 mM solution of the SAM-forming compound for 60 min using toluene as a solvent. To remove any impurity, unreacted silane molecules and solvent residues, the coupons were consecutively rinsed and sonicated for 30 s in clean toluene, ethanol and de-ionized water (DIW). All the chemicals were used as supplied. Finally, the coupons were dried under a nitrogen flow. Concerning the deposition of the thiols (11-mercapto-1-undecanol, 3-Mercapto-1-propanol, 4-aminothiophenol, 1-dodecanethiol, 1-propanethiol and 3-mercapto-1-propanol), the procedure consisted in the immersion of the clean SiO₂ and TiN surfaces in a 5 mM precursor solution for 60, 240 and 1440 min. using ethanol as a solvent. To remove any impurity, unreacted thiol molecules and solvent residues, the coupons were consecutively rinsed and sonicated for 30 s in clean ethanol and de-ionized water (DIW).

### Water contact angle (CA) SAM characterization.

In order to assess the quality of the SAMs film in terms of terminal groups availability, order, density, stability and the reproducibility of our deposition procedure, the macroscopic order after the deposition step was routinely monitored measuring the water CA on the SAMs surface. CA measurements were performed using an OCA 20 video-based device from Dataphysics. Measurements were made on sessile drops (1 µL droplets) of ultrapure water, using a Laplace-Young fitting to extract the contact angle values of the drop on the surface.

### B. Examples:

### Comparative example 1:

After pretreatment, the SiO₂ and the SiN samples have been contacted with the hydrophobic dodecyltriethoxysilane. Both SiO₂ and TiN gave a CA of ca. 90° after SAMs deposition as an indication of SAMs presence on both substrates. This result was achieved independently from differences in the substrates pre-clean conditions. This same result was maintained even after annealing of the SiO₂ and TiN samples up to 450°C for 20 min (no differential thermal desorption of the SAMs on TiN vs SiO₂). The pre-treatments that have been tried were the following:
● UV-Ozone (dual lamp 185nm-254nm 1 min.)
● UV-Ozone (dual lamp 185nm-254nm 2 min.)
● UV-Ozone (dual lamp 185nm-254nm 5 min.)
● Piranha (H₂SO₄:H₂O₂ 1:4, 1 min.)

The deposition times that have been tried were the following:
● 30 min.
● 60 min.

Dodecyltriethoxysilane does not selectively form SAMS on the SiO₂.

### Comparative example 2:

After pretreatment, the SiO₂ and the SiN samples have been contacted with the hydrophobic n-decyltriethoxysilane. Both SiO₂ and TiN gave a CA of ca. 90° after SAMs deposition as an indication of SAMs presence on both substrates. This result was achieved independently from differences in the substrates pre-clean conditions. This same result was maintained even after annealing of the SiO₂ and TiN samples up to 450°C for 20 min (no differential thermal desorption of the SAMs on TiN vs SiO₂). The pre-treatments that have been tried were the following:
● UV-Ozone (dual lamp 185nm-254nm 1 min.),
● UV-Ozone (dual lamp 185nm-254nm 2 min.),
● UV-Ozone (dual lamp 185nm-254nm 5 min.),
● UV-Ozone (dual lamp 185nm-254nm 15 min.),
● Piranha (H₂SO₄:H₂O₂ 1:4, 1 min.),
● HF 0.5% 5min.

The deposition times that have been tried were the following:
- 60 min.
- 240 min.

N-decyltriethoxysilane does not selectively form SAMS on the SiO₂.

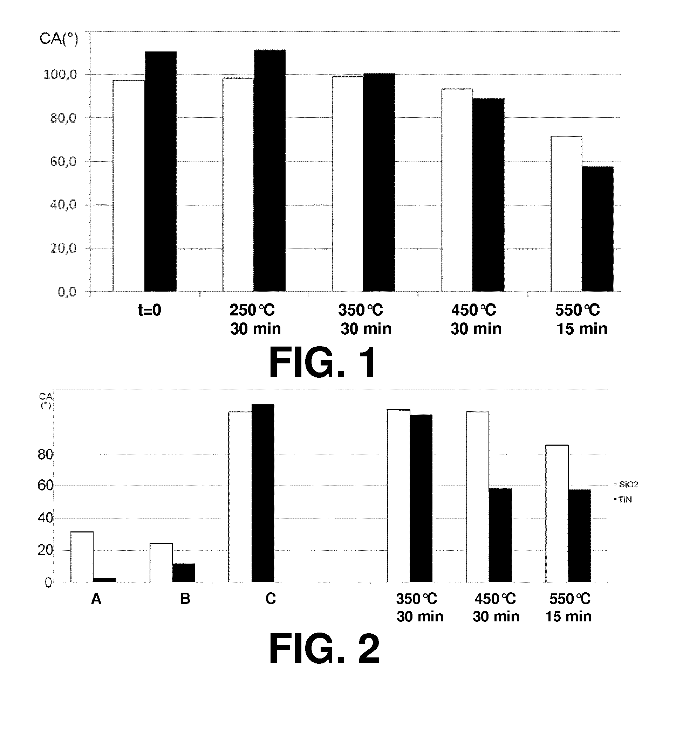

### Comparative example 3 (see Figure 1, white candlesticks are for SiO₂ and black candlesticks are for TiN):

After pretreatment, the SiO₂ and SiN samples have been contacted with the hydrophobic dodecyltrichlorosilane. Both SiO₂ and TiN gave a CA of ca. 100°-110° after SAMs deposition as an indication of SAMs presence on both substrates. This same result was maintained after annealing of the SiO₂ and TiN samples at 250°C for 30 min.

CA on TiN slightly decreased by ca. 10°after annealing of the SiO₂ and TiN samples at 350°C for 30 min. CA for both samples were therefore at ca. 100°. After annealing of the SiO₂ and TiN samples up to 450°C for 30 min, the CA on TiN was 5° lower than on SiO₂.

After annealing of the SiO₂ and TiN samples up to 550°C for 15 min, the CA measurements indicated a desorption of the SAMs from both the SiO₂ and the TiN.

The pre-treatment that has been followed is the following:
● UV-Ozone (dual lamp 185nm-254nm 15 min.)

The deposition times that have been tried were the following:
● 60 min.

Dodecyltrichlorosilane shows limited binding selectively to SiO₂ in presence of TiN.

### Example 1 (see Figure 2, white candlesticks are for SiO₂ and black candlesticks are for TiN)):

After pretreatment (A), a sacrificial thiol SAM (11-mercapto-1-undecanol in ethanol) was contacted with the SiO₂ and the TiN samples (B). This led to selective deposition on the TiN substrate, thereby passivating said substrate. Second, the passivated TiN and the SiO₂ substrates were contacted with a hydrophobic SAM forming compound (dodecyltrichlorosilane in toluene) (C). In view of the CA results (see figure 2, C), the deposition occurred on both the SiO₂ substrate and the passivated TiN substrate. An enhancement of the selectivity (measured as a 50° delta between the contact angle before and after annealing) was achieved via annealing at 450°C for 30 min. 15 min at 550°C led to an enhanced desorption of the hydrophobic SAMs from both substrates.

The pre-treatment that has been followed is the following:
● UV-Ozone (dual lamp 185nm-254nm 5 min.)

The deposition times that have been tried for the thiol SAM were:
● 60 min, 120 min, 180 min, and 24 h. The variation of the time did not lead to any significant differences.

This two SAMs procedure permitted to achieve selective formation of a dodecyltrichlorosilane SAM on SiO₂ in presence of TiN after annealing at 450°C for 30 min. A temperature of 550°C appeared to high.

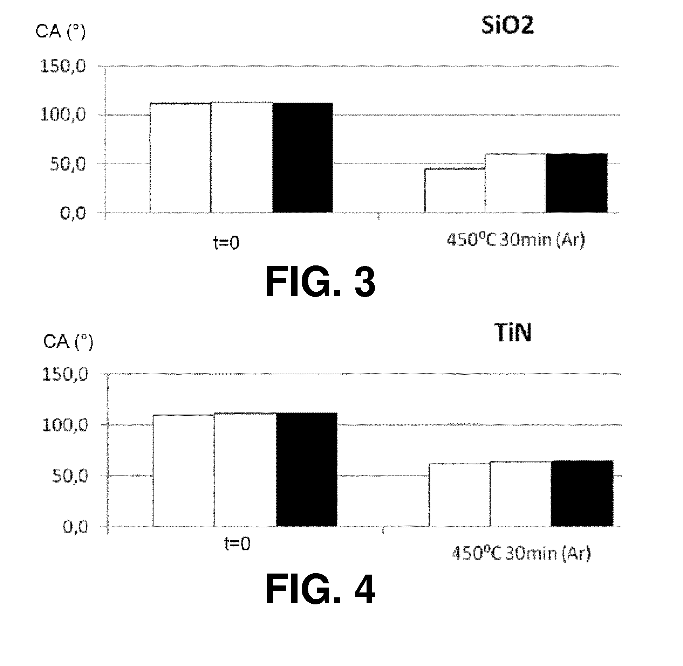

### Comparative example 4 (Figures 3 and 4)

After pretreatment, the SiO₂ and the TiN samples where sequentially contacted with two sacrificial thiols SAMs (11-mercapto-1-undecanol in ethanol, then 3-mercapto-1-propanol in ethanol). This led to selective deposition on the TiN substrate, thereby passivating said substrate. Then, the samples were contacted with a third SAM (dodecyltrichlorosilane in toluene). The CA results (see figures 3 (left) for SiO₂ and Figure 4 (left) for TiN) indicate that the third SAM was attached to both the SiO₂ substrate and the TiN substrate. The three candlesticks (white 1, white 2 and black) refer to a 60 min, a 240 min and a 24 h deposition time for 3-mercapto-1-propanol respectively. After the deposition, the samples were annealed at 450°C for 30 min (see Figure 3 (right) for SiO₂ and Figure 4 (right) for TiN). This treatment did not improve selectivity.

The pre-treatment that has been followed is the following:
- UV-Ozone (dual lamp 185nm-254nm 5 min.)

The deposition time that has been used for the thiol SAM 11-mercapto-1-undecanol was 24h.

The deposition times that have been used for 3-mercapto-1-propanol were 60 min, 240 min, and 24h. The variation of the time did not lead to any significant differences.

The deposition time that has been used for dodecyltrichlorosilane was 60 min. This three SAMs procedure did not permit to achieve selective formation of a SAM on SiO₂ in presence of TiN.

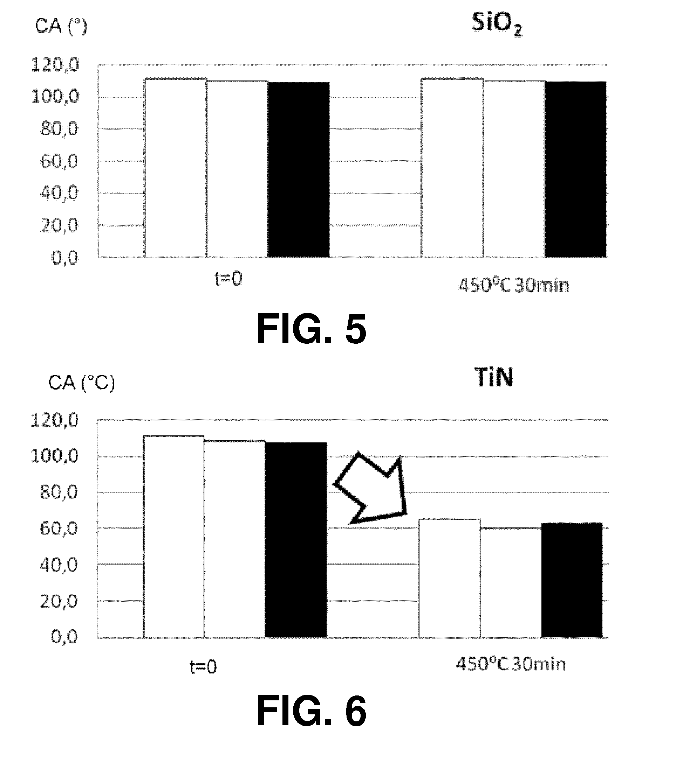

### Example 2 (see Figures 5 and 6):

After pretreatment, the SiO₂ and the TiN samples were contacted with a sacrificial thiol SAM (4-aminothiophenol in ethanol). This SAM deposited itself selectively on the TiN. Then, both samples were contacted with a hydrophobic SAM (dodecyltrichlorosilane in toluene). The CA results (see Figure 5 (left) for SiO₂ and Figure 6 (left) for TiN) indicated that the second SAM was attached to both the SiO₂ substrate and the TiN substrate. The three candlesticks (white 1, white 2 and black) refer to a 60 min, a 240 min and a 24 h deposition time for 4-aminothiophenol respectively. An enhancement of the selectivity (which results in a delta contact angle of 50°) was achieved via annealing at 450°C for 30 min (see Figure 5 (left) for SiO₂ and Figure 6 (left) for TiN).

The pre-treatment that has been followed is the following:
- UV-Ozone (dual lamp 185nm-254nm 5 min.)

The deposition times that have been used for 4-aminothiophenol were 60 min, 240 min, and 24h.

The deposition time that has been used for dodecyltrichlorosilane was 60 min. This two SAMs procedure permitted to achieve selective formation of a dodecyltrichlorosilane SAM on SiO₂ in presence of TiN after annealing at 450°C for 30 min.

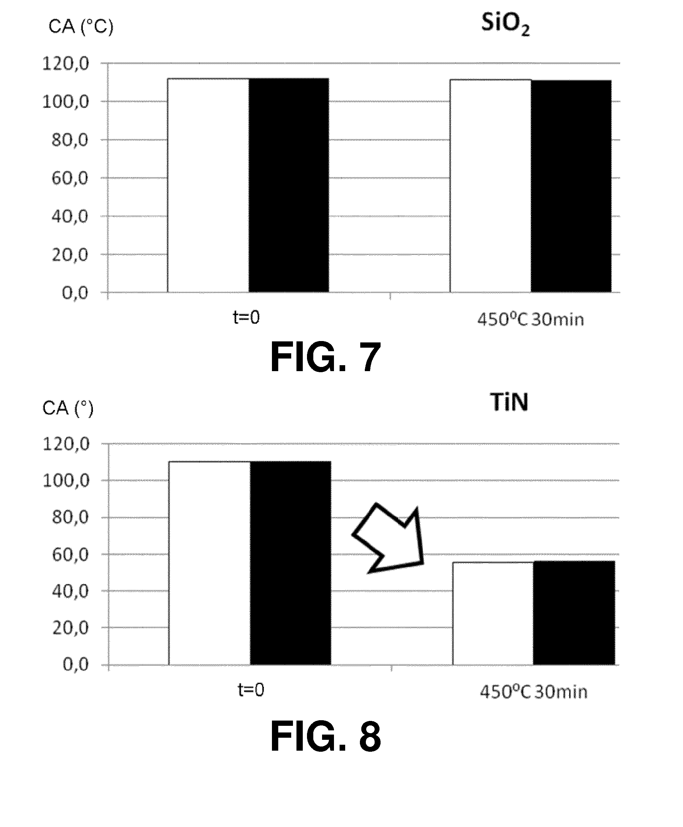

### Example 3 (see Figures 7 and 8):

After pretreatment, the SiO₂ and the TiN samples were contacted with a sacrificial thiol SAM (1-dodecanethiol in ethanol). This led to a selective deposition on TiN. Then, both samples were contacted with a second SAMs (dodecyltrichlorosilane in toluene). The CA results (see figures 7 and 8 where CA is ca. 110° for both the SiO₂ sample (Figure 7 left) and the TiN sample (Figure 8 left)) indicate that the second SAM was attached to both the SiO₂ substrate and the TiN substrate. The two candlesticks (white and black) refer to a 60 min and a 240 min deposition time for 1-dodecanethiol respectively. An enhancement of the selectivity (which results in a delta contact angle of about 55°) was achieved via annealing at 450°C for 30 min (see Figure 7 right and Figure 8 right).

The pre-treatment that has been followed is the following:
- UV-Ozone (dual lamp 185nm-254nm 5 min.)

The deposition times that have been used for 1-dodecanethiol were 60 min and 240 min. The variation of the time did not lead to any significant differences.

The deposition time that has been used for dodecyltrichlorosilane was 60 min. This two SAMs procedure permitted to achieve selective formation of a dodecyltrichlorosilane SAM on SiO₂ in presence of TiN after annealing at 450°C for 30 min.

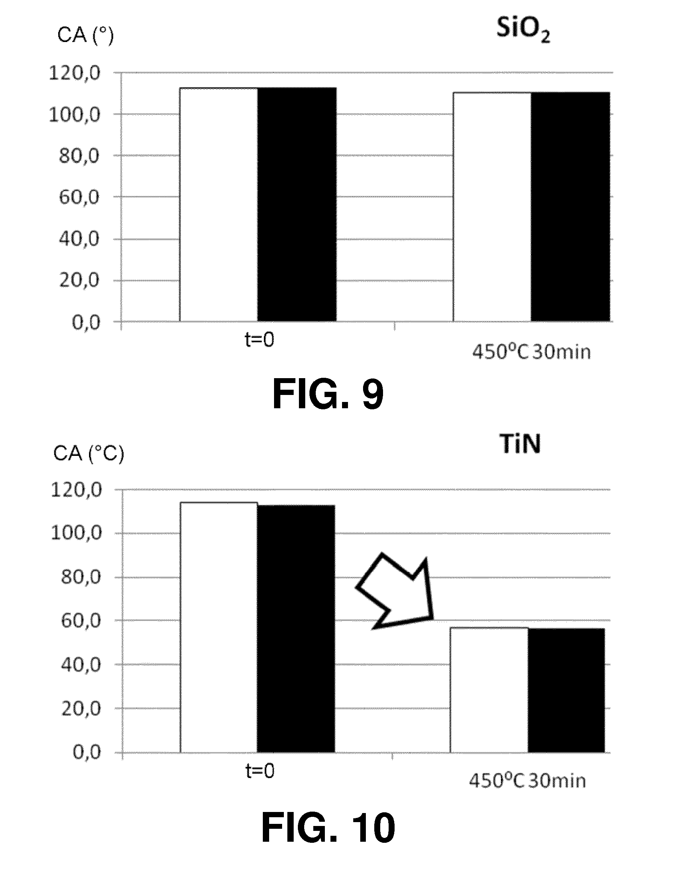

### Example 4 (see Figures 9 and 10):

After pretreatment, the SiO₂ and TiN samples were contacted with a sacrificial thiol SAM (1-propanethiol in ethanol). This led to a selective deposition on TiN. Then, both samples were contacted with a second SAMs (dodecyltrichlorosilane in toluene). The CA results (see figures 9 and 10 where CA is ca. 110° for both the SiO₂ sample (Figure 9 left) and the TiN sample (Figure 10 left)) indicate that the second SAM was attached to both the SiO₂ substrate and the TiN substrate. The two candlesticks (white and black) refer to a 60 min and a 240 min deposition time for 1-propanethiol respectively. An enhancement of the selectivity (which resulted in a delta contact angle of about 55°) was achieved via annealing at 450°C for 30 min (see Figure 9 right and Figure 10 right).

The pre-treatment that has been followed is the following:
● UV-Ozone (dual lamp 185nm-254nm 5 min.)

The deposition times that have been used for 1-propanethiol were 60 min and 240 min. The variation of the time did not lead to any significant differences.

The deposition time that has been used for dodecyltrichlorosilane was 60 min. This two-SAMs procedure permitted to achieve selective formation of a dodecyltrichlorosilane SAM on SiO₂ in presence of TiN after annealing at 450°C for 30 min.

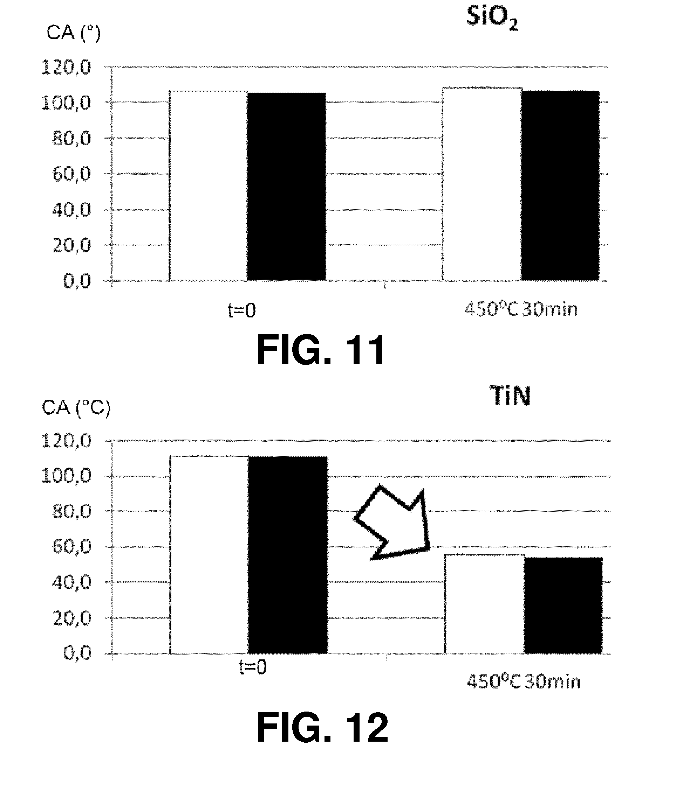

### Example 5 (see Figures 11 and 12):

After pretreatment, the SiO₂ and the TiN samples were contacted with a sacrificial thiol SAM (3-mercapto-1-propanol in ethanol). This led to a selective deposition on TiN. Then, a second SAMs (dodecyltrichlorosilane in toluene) was contacted with both samples. The CA results (see figures 11 and 12 where CA is ca. 110° for both the SiO₂ sample (Figure 11 left) and the TiN sample (Figure 12 left)) indicate that the second SAM was attached to both the SiO₂ substrate and the TiN substrate. The two candlesticks (white and black) refer to a 60 min and a 240 min deposition time for 3-mercapto-1-propanol respectively. An enhancement of the selectivity (which results in delta contact angle of about 55°) was achieved via annealing at 450°C for 30 min (see Figure 11 right and Figure 12 right).

The pre-treatment that has been followed is the following:
- UV-Ozone (dual lamp 185nm-254nm 5 min.)

The deposition times that have been used for 3-mercapto-1-propanol were 60 min and 240 min. The variation of the time did not lead to any significant differences.

The deposition time that has been used for dodecyltrichlorosilane was 60 min. This two-SAMs procedure permitted to achieve selective formation of a dodecyltrichlorosilane SAM on SiO₂ in presence of TiN after annealing at 450°C for 30 min.

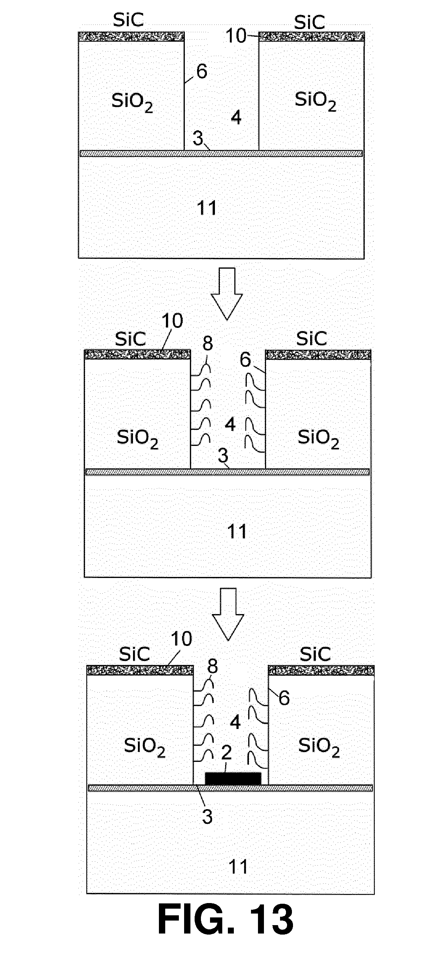

### Example 6 (see Figure 13):

In a first step, a substrate (5) is provided comprising a base substrate (11), a TiN or Metal silicide layer on top of said base substrate (11), a SiO₂ layer on top of said TiN or Metal silicide layer, and a SiC layer (10) on top of said SiO₂ layer. A via (4) is opened through said SiC layer (10) and said SiO₂ layer. The bottom (3) of the via (4) is therefore made of TiN or a metal silicide while the sidewall (6) of the via (4) is made of SiO₂.

In a second step, the chemical nature of the sidewall (6) surface is selectively modified by providing a hydrophobic self-assembled monolayer (8) thereon. This is made possible by the different chemical nature of the sidewall (6) (SiO₂) and the bottom (3) (TiN or Metal silicide).

In a third step, a 1-2 nm Ni, Co or Fe film (2) is deposited on said substrate (5) by use of an ALD or a CVD.

The resulting substrate (5) has a thin 1-2 nm Ni, Co or Fe film (2) in the bottom (3) of its via (4) but has no such film (2) on its sidewall (6).

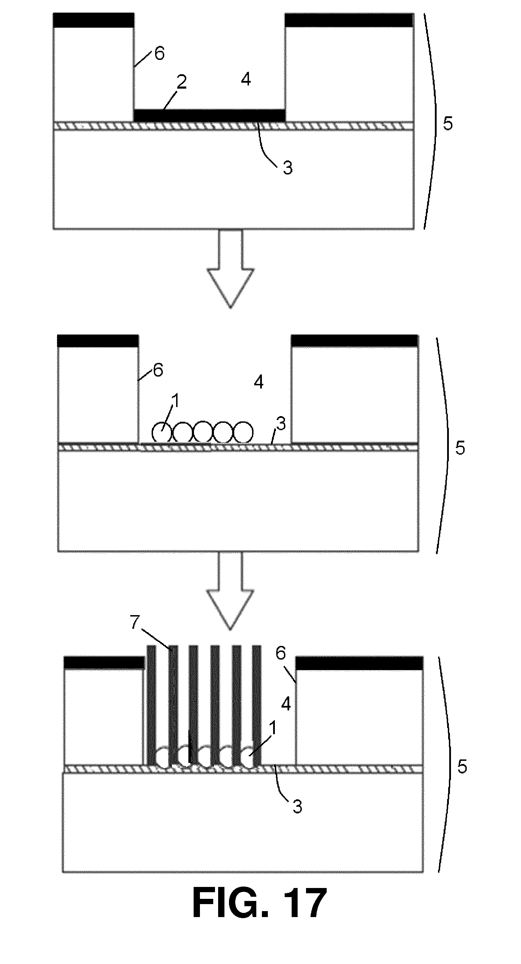

This modified substrate (5) can be used to grow carbon nanotubes (7) selectively from the bottom (3) of said via (4) (see Figure 17 and related description in example 9 below).

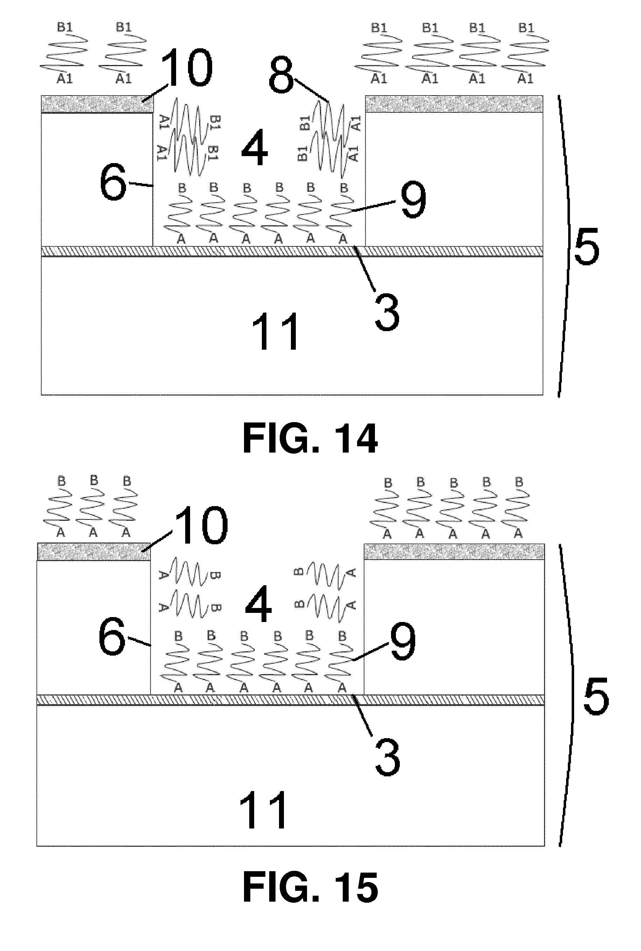

### Example 7 (see Figure 14):

In a first step, a substrate (5) is provided comprising a base substrate (11), a TiN or Metal silicide layer on top of said base substrate (11), a SiO₂ layer on top of said TiN or Metal silicide layer, and a SiC layer (10) on top of said SiO₂ layer. A via (4) is opened through said SiC layer (10) and said SiO₂ layer. The bottom (3) of the via (4) is therefore made of TiN or a metal silicide while the sidewall (6) of the via (4) is made of SiO₂.

In a second step, the chemical nature of the bottom (3) is selectively modified by providing a hydrophilic self-assembled monolayer (9) thereon. "A" in the monolayer (9) is a functional group having a greater affinity for the bottom (3) of the via (4) than for the sidewall (6). For instance, it is a thiol group. "B" is a hydrophilic group.

In a third step, the chemical nature of the sidewall (6) surface is selectively modified by providing a hydrophobic self-assembled monolayer (8) thereon. "A1" in the monolayer (8) is a functional group having a greater affinity for the sidewall (6) of the via (4) than for the bottom (3). For instance, it is a trialkoxysilane or a trichlorosilanes. This is made possible by the different chemical nature of the sidewall (6) (SiO₂) and the bottom (3) (TiN or Metal silicide) and by the fact that the bottom is passivated due to the presence of the hydrophilic self-assembled monolayer (9).

In a further step, a 1-2 nm Ni, Co or Fe film (2) is deposited on said substrate (5) by use of an ALD or a CVD.

The resulting substrate (5) has a thin 1-2 nm Ni, Co or Fe film (2) in the bottom (3) of its via (4) but has no such film (2) on its sidewall (6).

This modified substrate (5) can be used to grow carbon nanotubes (7) selectively from the bottom (3) of said via (4) (see Figure 17 and related description in example 9 below).

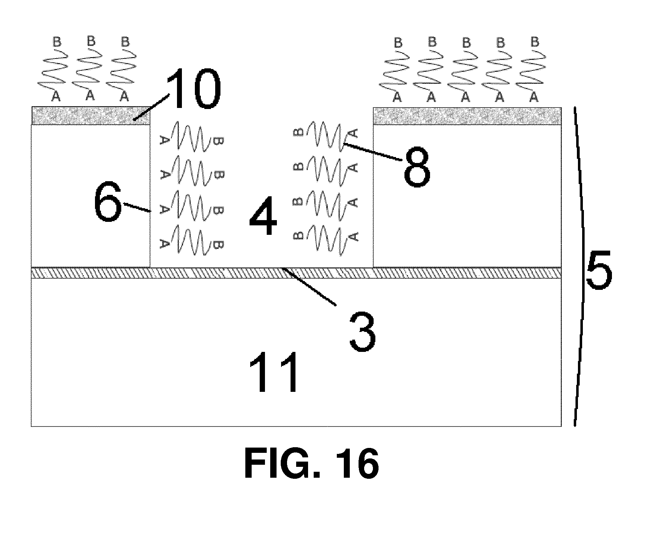

### Example 8 (see Figures 15 and 16):

In a first step, a substrate (5) is provided comprising a base substrate (11), a Al₂O₃, TiN or Metal silicide layer on top of said base substrate (11), a SiO₂ layer on top of said Al2O3, TiN or Metal silicide layer, and a SiC layer (10) on top of said SiO₂ layer. A via (4) is opened through said SiC layer (10) and said SiO₂ layer. The bottom (3) of the via (4) is therefore made of Al₂O₃, TiN or a metal silicide while the sidewall (6) of the via (4) is made of SiO₂.

In a second step, the chemical nature of the bottom (3) and of the sidewall (6) is modified by providing a self-assembled monolayer (9) thereon. "A" in the monolayer (9) is a functional group having a smaller (or identical) affinity for the bottom (3) of the via (4) than for the sidewall (6). For instance, it is a trialkoxysilane or a trichlorosilanes. "B" is a hydrophobic group.

In a third step, the bottom (3) of the via (4) is heated up so as to selectively desorb the self-assembled monolayer (9) thereon (see Figure 16).

In a further step, a 1-2 nm Ni, Co or Fe film (2) is deposited on said substrate (5) by use of an ALD or a CVD. The resulting substrate (5) has a thin 1-2 nm Ni, Co or Fe film (2) in the bottom (3) of its via (4) but has no such film (2) on its sidewall (6).This modified substrate (5) can be used to grow carbon nanotubes (7) selectively from the bottom (3) of said via (4) (see Figure 17 and related description in example 9 below).

### Example 9 (see Figure 17):

A modified substrate (5) as obtained at the end of any one of examples 6, 7 or 8 (i.e. having a film (2) precursor of catalyst nanoparticles (1) only on the bottom (3) of a recessed structure (4) thereof) can be used to grow carbon nanotubes (7) as follow. First, the film (2) is heated up and/or is plasma treated in order to form nanoparticles (1). Second, carbon nanotubes (7) are grown by CVD or PECVD.

## Claims

1. A method for growing elongated nanostructures (7) only on the bottom (3) of a recessed structure (4), the method comprising:
a. providing a substrate (5) comprising said recessed structure (4), said recessed structure (4) comprising:
o said bottom (3), said bottom (3) having a first affinity for said catalyst film (2), and
o at least one sidewall (6) having a second affinity for said catalyst film (2),
b. modifying the chemical nature of the surface of said at least one sidewall (6) so that said at least one sidewall (6) has a lower affinity than said bottom (3) for a catalyst film (2),
c. providing said catalyst film (2) onto said bottom (3) by either atomic layer deposition or chemical vapour deposition,
d. thermally and/or plasma treating said film (2) so as to form said catalyst nanoparticles (1), and
e. growing elongated nanostructures (7) in said recessed structure (4) using the catalyst nanoparticules (1) provided at the bottom (3) of said recessed structure (4).

2. The method according to claim 1, wherein said elongated nanostructures (7) are carbon nanotubes (7).

3. The method according to anyone of the preceding claims, wherein said bottom (3) and said at least one sidewall (6) are of different chemical natures.

4. The method according to any one of the preceding claims, wherein step (b) comprises providing a hydrophobic self-assembled monolayer (8) on said at least one sidewall (6).

5. The method of claim 4, wherein said hydrophobic self-assembled monolayer (8) is an organosilane (8).

6. The method according to claim any one of the preceding claims, further comprising a step (f) after step (a) and before step (b) comprising providing a self-assembled monolayer (9) on said bottom (3).

7. The method according to claim 6, wherein said self-assembled monolayer (9) is a monolayer of organosulfur compounds, preferably of a single organosulfur compound.

8. The method according to any one of the preceding claims, wherein said bottom (3) provided in step (a) is made of an electrically conductive material.

9. The method according to any one of the preceding claims, wherein said at least one sidewall (6) provided in step (a) is made of a dielectric material.

10. The method according to any one of the preceding claims wherein said recessed structure (4) has an aspect ratio of 15 or more.

11. The method according to any one of the preceding claims, wherein said bottom (3) is made of titanium nitride.

12. The method according to any one of the preceding claims, wherein said catalyst nanoparticles (1) are made of Ni, Co or Fe.

13. The method according to claim 3, wherein step (b) comprises:
i. Selectively providing a self-assembled monolayer (9) on said bottom,
ii. providing a hydrophobic self-assembled monolayer (8) on said at least one sidewall so as to decrease its affinity for said catalyst nanoparticles (1) and/or said precursor (2) below said first affinity, and
iii. heating up said bottom (3) so as to selectively remove at least part of said self-assembled monolayer (9) from said bottom (3).

14. The method according to claim 13, wherein the self-assembled monolayer (9) provided on said bottom (3) is selected so as to be more easily thermally desorbed from said bottom (3) than said hydrophobic self― assembled monolayer (8) from said at least one sidewall (6).

15. The method according to any one of the preceding claims wherein said elongated nanostructures (7) are a bundle of elongated nanostructures (7) for forming an interconnect structure.

16. A substrate (5) comprising a recessed structure (4) having a bottom (3) and at least one sidewall (6), said recessed structure (4) having elongated nanostructures (7) selectively on said bottom (3), said substrate further comprising a hydrophobic self-assembled monolayer (8) on said at least one sidewall (6).
